Europäisches Patentamt

European Patent Office

Office européen des brevets

(11) Veröffentlichungsnummer: **0 307 776 B1**

# (12) EUROPÄISCHE PATENTSCHRIFT

(45) Veröffentlichungstag der Patentschrift: **11.08.93**

(51) Int. Cl.5: **G03F 7/075**, G03F 7/11

(21) Anmeldenummer: **88114587.4**

(22) Anmeldetag: **07.09.88**

(54) **Lichtempfindliche Druckplatte für den wasserlosen Flachdruck.**

(30) Priorität: **18.09.87 DE 3731438**

(43) Veröffentlichungstag der Anmeldung:
**22.03.89 Patentblatt 89/12**

(45) Bekanntmachung des Hinweises auf die
Patenterteilung:
**11.08.93 Patentblatt 93/32**

(84) Benannte Vertragsstaaten:
**DE FR GB**

(56) Entgegenhaltungen:
**DE-A- 2 350 211**
**DE-A- 3 702 839**

(73) Patentinhaber: **HOECHST AKTIENGESELL-SCHAFT**

**W-6230 Frankfurt am Main 80(DE)**

(72) Erfinder: **Schlosser, Hans-Joachim, Dr.**
**Am Rosengarten 2a**
**W-6200 Wiesbaden(DE)**

## Beschreibung

Die Erfindung betrifft eine lichtempfindliche Druckplatte mit einem Schichtträger, einer lichtempfindlichen Schicht und einer darüberliegenden, Druckfarbe abstoßenden Schicht aus Silikonkautschuk.

Druckplatten der genannten Art sind z. B. aus der DE-A 16 71 637 bekannt. Als lichtempfindliche Schichten werden darin bevorzugt solche auf Basis von Polykondensationsprodukten aus aromatischen Diazoniumsalzen und Formaldehyd eingesetzt. Diese Schichten werden durch Belichten im Entwickler unlöslich und können mit wäßrigen Lösungen entwickelt werden. Bei der Entwicklung werden die Bereiche der Silikonkautschukschicht, die über den löslichen, ungehärteten Bereichen der lichtempfindlichen Schicht liegen, zusammen mit diesen löslichen Bereichen entfernt, obwohl sie im Entwickler unlöslich sind. Allerdings ist es erforderlich, dem Entwickler organische Lösungsmittel in ausreichendem Maße zuzusetzen, daß der Silikonkautschuk darin gequollen und dadurch erweicht wird. Zur Entwicklung werden z. B. Gemische von Isopropanol und Wasser verwendet.

Als Silikonkautschuke werden hierfür Einkomponentenkautschuke eingesetzt, die zum Aushärten nach dem Aufbringen der Schicht Feuchtigkeit benötigen und längere Zeit erfordern. Solche Einkomponenten-Silikonkautschuke sind gewöhnlich Polysiloxane, z. B. Dimethylpolysiloxane, die endständige Acetyl-, Oxim-, Hydroxy- oder Aminogruppen enthalten.

In der DE-A 23 23 972 ist eine ähnliche Platte mit einem Einkomponenten-Silikonkautschuk beschrieben, deren lichtempfindliche Schicht ein Reaktionsprodukt aus einem Diphenylamin-4-diazoniumsalz-Formaldehyd-Kondensationsprodukt und der 2-Hydroxy-4-methoxy-benzophenon-5-sulfonsäure und gegebenenfalls ein Bindemittel enthält. Da das Diazoniumsalz-Fällungsprodukt sehr schwerlöslich ist, wird sowohl die Herstellung als auch die Entwicklung der Platte erheblich erschwert.

In der DE-A 23 57 871 sind auch vorsensibilisierte Druckplatten für den wasserlosen Offsetdruck beschrieben, die eine Mehrkomponenten-Silikonkautschukschicht enthalten. Diese Schichten enthalten neben Organopolysiloxanen z. B. niedermolekulare Silane, die mit funktionellen Endgruppen der Polysiloxane unter Vernetzung in Abwesenheit von Feuchtigkeit zu reagieren vermögen. Diese Mehrkomponentensysteme können durch Additions- oder Kondensationsreaktionen vernetzen. Beim Additionstyp, wie er in der genannten DE-A beschrieben ist, reagieren z. B. endständige Alkenylgruppen mit Si-H-Gruppen in Gegenwart von Katalysatoren bei erhöhter Temperatur. Er ergibt Platten mit guter Farbabstoßung und leichter Entwickelbarkeit. Allerdings sind die Schichten oft kratzempfindlich, so daß bei der Handhabung in der Druckmaschine Kratzer in der Silikonoberfläche auftreten, die mitdrucken und die Druckplatte wertlos machen. Bei den kondensationsvernetzenden Systemen reagieren endständige funktionelle Gruppen von Polydiorganosiloxanen mit funktionellen Gruppen von Silanen oder Oligosiloxanen, die als Vernetzer wirken, zumeist in Gegenwart von Katalysatoren.

Die mit diesen Silikongummischichten erhaltenen Druckplatten zeigen eine gute Farbabweisung an den Nichtbildstellen und bei hoher Vernetzungsdichte eine ausgezeichnete Kratzfestigkeit der farbabweisenden Silikonschicht. Allerdings sind Druckplatten mit solchen Schichten sehr schwer zu entwickeln und die zu erzielende Auflösung der Bildelemente ist ungenügend.

In der DE-A 29 41 254 wird beschrieben, daß zwischen lichtempfindlicher Schicht und Silikongummischicht ein sogenanntes Grundierungsmittel dünn aufgetragen wird, um die Haftung zwischen diesen Schichten zu verbessern. Als Silikongrundierungen oder Silikonkupplungsmittel werden z. B. Alkyl-, Aminoalkyl- und Alkoxysilane genannt.

Sie dienen nur zur Verbesserung der Haftung des Silikongummis auf der lichtempfindlichen Schicht.

Aufgabe der Erfindung ist es, eine wasserlos druckende Flach-, insbesondere Offsetplatte mit hoher Kratzfestigkeit der Oberfläche bereitzustellen, die sich zugleich in kurzer Zeit entwickeln läßt und eine gute Bildauflösung ergibt.

Erfindungsgemäß wird eine lichtempfindliche Druckplatte für den wasserlosen Flachdruck aus einem Schichtträger, einer darauf aufliegenden lichtempfindlichen Schicht und einer äußeren, Druckfarbe abstoßenden Silikongummischicht vorgeschlagen.

Die erfindungsgemäße Druckplatte ist dadurch gekennzeichnet, daß sich zwischen lichtempfindlicher Schicht und äußerer Silikongummischicht eine innere, Druckfarbe abstoßende Silikongummischicht befindet und daß die äußere Silikongummischicht stärker vernetzt ist als die innere Schicht.

Erfindungsgemäß wird ferner ein Verfahren zur Herstellung einer lichtempfindlichen Druckplatte für den wasserlosen Flachdruck vorgeschlagen, das dadurch gekennzeichnet ist, daß man auf einen Schichtträger eine lichtempfindliche Schicht aufbringt, auf die lichtempfindliche Schicht eine Lösung eines additionsvernetzbaren Mehrkomponenten-Silikonkautschuks oder eines Einkomponenten-Silikonkautschuks aufbringt und bei erhöhter Temperatur trocknet und auf die getrocknete und mindestens teilweise vernetzte Silikonkautschukschicht eine Lösung eines kondensationsvernetzbaren Mehrkomponenten-Silikonkautschuks aufbringt und bei erhöhter Temperatur bis zur vollständigen Vernetzung trocknet.

Als "Silikonkautschuk" soll im Rahmen dieser Erfindung entsprechend der Definition von Noll, "Chemie und Technologie der Silikone", Verlag Chemie, 1968, S. 332, ein hochmolekulares, im wesentlichen lineares Diorganopolysiloxan bezeichnet werden, während für die vernetzten bzw. vulkanisierten Produkte die Bezeichnung "Silikongummi" verwendet wird.

Wesentliches Merkmal der Erfindung ist es, daß die äußere Silikongummischicht stärker vernetzt ist als die innere. Überraschenderweise folgt diese stark vernetzte Schicht beim Entwickeln genau den Umrissen der Bildelemente der darunterliegenden lichtempfindlichen Schicht. Eine erfindungsgemäße Druckplatte mit der vorstehend definierten doppelten Silikongummischicht zeigt deshalb eine höhere Bildauflösung als eine entsprechende Platte, die nur eine stark vernetzte Silikongummischicht und keine weniger stark vernetzte innere Silikongummischicht aufweist.

Grundsätzlich ist es möglich, den unterschiedlichen Vernetzungs- und damit Härtegrad der Silikonschichten unter Einsatz von untereinander gleichen oder von beliebigen Silikonkautschuken in der inneren und äußeren Schicht durch geeignete Wahl von Vernetzungsmitteln und bzw. oder von Vernetzungsbedingungen zu erreichen. Mit Vorteil werden aber unterschiedliche Silikonkautschuke eingesetzt. Dabei verwendet man für die innere, weniger stark zu vernetzende Schicht vorzugsweise Einkomponenten-Silikonkautschuke oder additionsvernetzbare Mehrkomponenten-Silikonkautschuke und für die äußere, stärker zu vernetzende Schicht kondensationsvernetzbare Mehrkomponenten-Silikonkautschuke.

Die Einkomponenten-Silikonkautschuke basieren normalerweise auf Polysiloxanen, die z. B. endständige Acetyl-, Oxim-, Alkoxy- oder Aminogruppen oder Wasserstoffatome enthalten. Im übrigen besteht das Polysiloxan im wesentlichen aus einer Dimethylpolysiloxankette. Die Methylgruppen können in geringerem Umfang auch durch andere Alkylgruppen, durch Halogenalkylgruppen oder substituierte oder unsubstituierte Arylgruppen ersetzt sein. Die endständigen funktionellen Gruppen sind leicht hydrolysierbar und härten bei Feuchtigkeitseinwirkung innerhalb von einigen Minuten bis Stunden aus.

Die additionsvernetzbaren Mehrkomponenten-Silikonkautschuke enthalten im allgemeinen Polysiloxane mit Alkenylgruppen als Substituenten und solche mit an Silicium gebundenen Wasserstoffatomen. Sie werden in Gegenwart von Platinkatalysatoren bei Temperaturen oberhalb 50° C vernetzt. Sie haben den Vorteil, daß sie bei höherer Temperatur, z. B. um 100° C, schnell vernetzen. Dafür kann auch die Verarbeitungsdauer (Topfzeit) dieser Systeme relativ kurz sein. Solche Systeme sind z. B. in der DE-A 26 54 893 beschrieben. Es sind durch Addition vernetzbare Mehrkomponenten-Silikonkautschuke aus

a) Diorganopolysiloxanen mit endständigen Si-Vinylgruppen,

b) Organopolysiloxanen mit mindestens drei an Silicium gebundenen Wasserstoffatomen,

c) Platinkomplexen von Vinylsiloxanen und

d) einem Mittel, das die Anlagerung von an Silicium gebundenen Wasserstoffatomen an aliphatische Mehrfachbindungen bei Raumtemperatur verzögert.

Die additionsvernetzenden Kautschuke ergeben gute Haftung und hohe Druckkstandfestigkeit, besitzen dann aber zumeist eine höhere Kratzempfindlichkeit.

Die durch Kondensation vernetzbaren Gemische enthalten Diorganopolysiloxane mit reaktionsfähigen Endgruppen, z. B. OH- und Acetoxygruppen. Diese werden mit reaktiven Silanen oder Oligosiloxanen in Gegenwart von Katalysatoren vernetzt. Auch diese Kombinationen reagieren relativ schnell und haben deshalb eine begrenzte Topfzeit.

Mit besonderem Vorteil werden durch Kondensation vernetzbare Mehrkomponenten-Silikonkautschuke eingesetzt, wie sie in der DE-C 21 19 120 beschrieben sind.

Diese bevorzugten Silikonkautschuke sind durch Kondensation vernetzbare Kombinationen aus a) Diorganopolysiloxanen mit endständigen Si-OH-Gruppen; b) Organopolysiloxanen, die an Silicium gebundene Wasserstoffatome, aber keine Aminogruppen enthalten; c) aminosubstituierten Organosiliciumverbindungen und d) katalytisch wirkenden Organozinnverbindungen.

Sie weisen eine hohe Kratzfestigkeit auf. Die Stabilität kann durch Zugabe von weiteren Organosilanen, insbesondere von aminosubstituierten Organisiliciumverbindungen weiter erhöht werden. Allerdings sinkt bei alleiniger Verwendung dieser Silikonkautschuke bei der Herstellung von wasserlos druckenden Offsetplatten die Entwickelbarkeit und erreichbare Auflösung.

Der Silikonkautschuk der inneren Schicht wird nach dem Aufbringen als Schicht in bekannter Weise durch Feuchtigkeitseinwirkung oder aus sich heraus bei Raumtemperatur oder erhöhter Temperatur zu einem in organischen Lösemitteln im wesentlichen unlöslichen Silikongummi vernetzt. Die fertige Silikongummischicht hat im allgemeinen eine Dicke von 0,1 bis 10, bevorzugt von 0,4 bis 5 μm. Die Beschichtung erfolgt im allgemeinen aus unpolaren Lösemitteln, z. B. Paraffinkohlenwasserstoffen, die die darunterliegende lichtempfindliche Schicht wenig oder gar nicht lösen.

Die Beschichtung wird dann zur Entfernung des Lösemittels bei erhöhter Temperatur getrocknet und der Kautschuk dabei mindestens teilweise vernetzt. Auf die erhaltene Schicht wird dann eine Lösung des Silikonkautschuks für die äußere Schicht in organischem Lösemittel aufgebracht und zu einer im wesentlichen unlöslichen, auf der inneren Silikonschicht fest haftenden Silikongummischicht vernetzt. Die Dicke der äußeren Silikongummischicht beträgt im allgemeinen 0,2 bis 10, vorzugsweise 0,5 bis 5 $\mu$m.

Die für die Deckschicht bevorzugten kondensationsvernetzbaren Silikonkautschuke ergeben Druckplatten, deren Nichtbildstellen weniger Neigung zum Tonen aufweisen als solche, die z. B. mit Einkomponenten-Silikonkautschuken hergestellt worden sind. Vor allem weisen sie eine hohe Kratzfestigkeit auf.

Unterhalb der Silikongummischichten befindet sich in an sich bekannter Weise die lichtempfindliche Schicht. Als lichtempfindliche Substanzen sind sowohl positiv arbeitende (durch Belichtung löslich werdende) als auch negativ arbeitende (lichthärtbare) Systeme geeignet.

Als Positivschichten, die infolge der Bildumkehr durch den wasserlosen Offsetdruck negativ druckende Platten ergeben, sind die bekannten lichtempfindlichen Gemische auf Basis von 1,2-Chinondiaziden oder von säurespaltbaren Verbindungen geeignet. 1,2-Chinondiazide sind bekannt und z. B. in den DE-C 938 233 und 1 543 721, den DE-A 23 31 377, 25 47 905 und 28 28 037 beschrieben. Als 1,2-Chinondiazide werden bevorzugt 1,2-Naphthochinon-2-diazid-4- oder -5-sulfonsäureester oder -amide verwendet. Von diesen werden die Ester, insbesondere die der 5-Sulfonsäure, besonders bevorzugt. Die Menge an 1,2-Chinondiazidverbindungen beträgt im allgemeinen 3 bis 50, bevorzugt 7 bis 35 Gew.-%, bezogen auf die nichtflüchtigen Anteile der Schicht. Weitere Schichtbestandteile sind vor allem wasserunlösliche, in wäßrig-alkalischen Lösungen lösliche Bindemittel.

Als alkalilösliche bzw. in Alkali quellbare Bindemittel sind synthetische Harze wie Mischpolymerisate aus Styrol und Maleinsäureanhydrid sowie insbesondere Novolake zu nennen. Der Anteil der alkalilöslichen Harze am Gesamtfeststoff liegt zwischen 30 und 90, besonders bevorzugt bei 55 - 85 Gew.-%. Statt oder im Gemisch mit Novolaken sind vorteilhaft auch Phenolharze vom Typ des Poly(4-vinyl-phenols) verwendbar. Zusätzlich können noch andere Harze mitverwendet werden, die nicht alkalilöslich oder aber wasserlöslich sind. Der günstigste Anteil an diesen Harzen beträgt im allgemeinen nicht mehr als 20 % vom alkalilöslichen Harz. In geringen Mengen kann die lichtempfindliche Schicht außerdem Substanzen wie Polyglykole, Cellulosederivate wie Ethylcellulose, Netzmittel, Farbstoffe und feinteilige Pigmente sowie bei Bedarf UV-Absorber enthalten.

Andere geeignete positiv arbeitende Schichten sind solche aus Kombinationen von Verbindungen, die bei Bestrahlung eine starke Säure bilden, und Verbindungen, die mindestens eine durch Säure spaltbare C-O-C-Bindung enthalten.

Die Schicht kann als Verbindungen mit säurespaltbaren C-O-C-Bindungen unter anderem monomere und polymere Acetale, monomere und polymere Orthocarbonsäureester, Enolether und N-Acyliminocarbonate enthalten. Solche Gemische sind in den DE-C 26 10 842 und 27 18 254, der EP-B 22 571 und den EP-A 6626 und 6627 beschrieben. Dabei werden polymere Acetale und Orthocarbonsäureester besonders bevorzugt. Der Mengenanteil an säurespaltbarer Verbindung beträgt im allgemeinen 2 bis 75, vorzugsweise 4 bis 30 Gew.-%, bezogen auf die nichtflüchtigen Bestandteile der Schicht.

Als strahlungsempfindliche Komponenten, die beim Bestrahlen vorzugsweise starke Säuren bilden bzw. abspalten, sind eine große Anzahl von bekannten Verbindungen und Mischungen, wie Diazonium-, Phosphonium-, Sulfonium- und Jodonium-Salze, Halogen-Verbindungen, o-Chinondiazidsulfochloride und Organometall-Organohalogen-Kombinationen geeignet. Grundsätzlich sind als halogenhaltige strahlungsempfindliche und Halogenwasserstoffsäure bildende Verbindungen alle auch als photochemische Radikalstarter bekannten organischen Halogenverbindungen, beispielsweise solche mit mehr als einem Halogentom an einem Kohlenstoffatom oder an einem aromatischen Ring, brauchbar. Beispiele sind in den US-A 3 515 552, 3 536 489 und 3 779 778, der DE-B 26 10 842 und den DE-A 27 18 259 und 22 43 621 beschrieben.

Die Menge des Starters kann je nach seiner chemischen Natur und der Zusammensetzung des Gemischs ebenfalls sehr verschieden sein. Günstige Ergebnisse werden erhalten mit etwa 0,1 bis 10 Gew.-%, bezogen auf den Gesamtfeststoff, bevorzugt sind 0,2 bis 5 %.

Die Gemische enthalten ferner polymere Bindemittel, wie sie vorstehend für Chinondiazidchichten beschrieben wurden. Das Gewicht der positiv arbeitenden lichtempfindlichen Schicht liegt im allgemeinen bei 0,3 bis 3 g/m$^2$, Schichtgewichte von etwa 0,8 bis 1,8 g/m$^2$ werden in den meisten Fällen bevorzugt.

Als negativ arbeitende Schichten sind u. a. solche aus photopolymerisierbaren Gemischen, lichtvernetzbaren Polymeren, Diazoniumsalz-Polykondensationsprodukten und Azidoverbindungen geeignet.

Geeignete photopolymerisierbare Gemische enthalten eine polymerisierbare Verbindung mit mindestens zwei endständigen ethylenisch ungesättigten Doppelbindungen, ein polymeres Bindemittel und einen Photoinitiator, der unter Einwirkung von aktinischer Strahlung die radikalische Polymerisation der ethylenisch ungesättigten Verbindung einzuleiten vermag. Als weitere Bestandteile kann die Schicht Stabilisatoren bzw. Inhibitoren zur Verhinderung der Dunkelpolymerisation der Monomeren, Wasserstoffdonatoren, Netzmittel, Weichmacher, sensitometrische Regler, Farbstoffe und farblose oder Farbpigmente enthalten.

Die Photoinitiatoren werden im allgemeinen in einer Menge von 0,01 bis 10, bevorzugt von 0,2 bis 5 Gew.-%, bezogen auf die nichtflüchtigen Bestandteile der photopolymerisierbaren Schicht, zugesetzt.

Für die Zwecke der Erfindung geeignete photopolymerisierbare Monomere sind bekannt und z. B. in den US-A 2 760 863 und 3 060 023 beschrieben. Bevorzugte Beispiele sind Acryl- und Methacrylsäureester, wie Polyethylenglykoldimethacrylat, Acrylate und Methacrylate von Trimethylolethan, Trimethylolpropan und Pentaerythrit und von mehrwertigen alicyclischen Alkoholen. Der Mengenanteil der Schicht an Monomeren beträgt im allgemeinen etwa 10 bis 80, vorzugsweise 20 bis 60 Gew.-%.

Als Bindemittel sind z. B. Acrylharze, Polyvinylacetale, Polyvinylester, Maleinatharze, Polymerisate aus N-(p-Tolyl-sulfonyl)-carbaminsäure-($\beta$-methacryloyloxy-ethyl)ester und Mischpolymerisate dieser und ähnlicher Monomerer mit anderen Monomeren sowie Styrol-Maleinsäureanhydrid-Mischpolymerisate, Methylmethacrylat-Methacrylsäure-Mischpolymerisate und Mischpolymerisate aus Methacrylsäure, Alkylmethacrylaten und Methylmethacrylat und/oder Styrol, Acrylnitril u. a., geeignet. Die Menge des Bindemittels beträgt im allgemeinen 20 bis 90, vorzugsweise 40 bis 80 Gew.-% der Bestandteile der Schicht.

Als Diazoniumsalz-Polykondensationsprodukte sind Kondensationsprodukte kondensationsfähiger aromatischer Diazoniumsalze, z. B. von Diphenylamin-4-diazoniumsalzen, mit Aldehyden, bevorzugt Formaldehyd, geeignet. Mit besonderem Vorteil werden Mischkondensationsprodukte verwendet, die außer den Diazoniumsalzeinheiten noch andere, nicht lichtempfindliche Einheiten enthalten, die von kondensationsfähigen Verbindungen, insbesondere aromatischen Aminen, Phenolen, Phenoläthern, aromatischen Thioäthern, aromatischen Kohlenwasserstoffen, aromatischen Heterocyclen und organischen Säureamiden, abgeleitet sind. Diese Kondensationsprodukte sind in der US-A 3 867 147 beschrieben. Allgemein sind alle Diazoniumsalz-Polykondensationsprodukte geeignet, die in der US-A 4 186 017 beschrieben sind.

Die lichtempfindlichen Schichten mit Diazoniumsalz-Kondensationsprodukten können außerdem Bindemittel, Farbstoffe, Indikatoren, Pigmente, Stabilisatoren, Netzmittel und weitere übliche Zusätze enthalten. Mit Vorteil werden wasserunlösliche harzartige Bindemittel, insbesondere in Kombination mit den bevorzugten Mischkondensationsprodukten von Diazoniumsalzen, verwendet. Beispiele für geeignete Bindemittel sind Polyalkylacrylate, Polyvinylacetale und Umsetzungsprodukte von Dicarbonsäureanhydriden, z. B. Malein- oder Phthalsäureanhydrid, mit OH-Gruppen enthaltenden Polymeren, wie Polyvinylacetalen, Polyvinylalkoholen oder teilverseiften Polyvinylacetaten. Derartige Bindemittel sind in der EP-A 152 819 beschrieben.

Die lichtempfindlichen Schichten auf Basis von Diazoniumsalz-Kondensationsprodukten enthalten im allgemeinen 5 bis 90, bevorzugt 10 bis 70 Gew.-% Diazoniumverbindung und 95 bis 10, bevorzugt 90 bis 30 Gew.-% polymeres Bindemittel.

Zur Stabilisierung dieser lichtempfindlichen Schicht ist es vorteilhaft, ihr eine Verbindung mit Säurecharakter zuzusetzen. In Betracht kommen Mineralsäuren und starke organische Säuren, von denen Phosphorsäure, Schwefelsäure, Perchlorsäure, Borsäure oder p-Toluolsulfonsäure bevorzugt werden. Eine besonders gut geeignete Säure ist die Phosphorsäure.

Als lichtvernetzbare Verbindungen sind ferner Polyvinylcinnamate, Chalkonderivate und aromatische Azide geeignet.

Das Gewicht der negativ arbeitenden lichtempfindlichen Schicht liegt im allgemeinen bei 0,3 bis 10 g/m², Schichtgewichte von etwa 0,8 bis 3 g/m² werden in den meisten Fällen bevorzugt.

Als Schichtträger werden meist Metalle verwendet. Dabei können eingesetzt werden: walzblankes, mechanisch oder elektrochemisch aufgerauhtes und gegebenenfalls anodisiertes Aluminium, das zudem noch chemisch, z. B. mit Polyvinylphosphonsäure, Silikaten, Phosphaten, Hexafluorozirkonaten oder mit hydrolysiertem Tetraethylorthosilikat, vorbehandelt sein kann. Weitere geeignete Metalle sind Stahl und Chrom. Da es, im Gegensatz zu üblichen Flachdruckplatten, nicht erforderlich ist, daß die Trägeroberfläche hydrophil ist, können mit Vorteil auch Kupfer, Messing oder andere oleophile Metalle als Trägeroberfläche dienen. Ebenso können Kunststoffolien, wie Polyester-, Polycarbonat-, Polyimid- oder auch Celluloseacetatfolien verwendet werden, deren Oberfläche ggf. zur Erhöhung der Benetzbarkeit durch Druckfarbe vorbehandelt sein kann. Auch gummielastische Trägermaterialien sind geeignet; mit solchen Trägern kann auch im direkten Flachdruck gedruckt werden.

Das Trägermaterial dient bei den Druckformen, die aus dem erfindungsgemäßen Material hergestellt werden, im Gegensatz zu sonst üblichen Druckformen, als farbführendes Material. Die nach dem Belichten und Entwickeln stehengebliebene Silikongummischicht dient als Bildhintergrund und wirkt in trockenem Zustand farbabstoßend. Zum Druck können dabei sowohl übliche Druckfarben auf Ölbasis als auch spezielle hydrophile Druckfarben dienen, wie sie für den wasserlosen Offsetdruck sowie für den umgekehrten Offsetdruck entwickelt wurden und im Handel erhältlich sind. Da die meisten gebräuchlichen Schichtträgeroberflächen, z. B. aufgerauhtes oder anodisch oxydiertes Aluminium, stark hydrophil sind, werden hydrophile Druckfarben mit Vorteil eingesetzt.

Zur Entwicklung der belichteten Druckplatten werden bevorzugt Gemische von organischen Lösemitteln untereinander oder mit Wasser verwendet. Dabei wird ein Bestandteil gewählt, der die Silikongummischichten zu quellen vermag, und ein Bestandteil, der die belichtete lichtempfindliche Schicht selektiv auflöst. Beispiele für geeignete Entwickler sind Kombinationen von Paraffinkohlenwasserstoffen mit polaren Lösemitteln, wie Estern, Ketonen oder Alkoholen. Geeignet sind auch Kombinationen von mit Wasser mischbaren Lösemitteln, wie niederen Alkoholen oder Ketonen, und Wasser.

Im folgenden werden Beispiele für bevorzugte Ausführungsformen der Erfindung beschrieben. Wenn nichts anderes angegeben ist, sind Mengenverhältnisse und Prozentangaben auf das Gewicht bezogen. Vor den Ausführungsbeispielen werden die verwendeten Silikonkautschuklösungen beschrieben.

Verwendete Silikonkautschuklösungen

A) Eine handelsübliche 60 %ige Lösung eines bei Raumtemperatur vernetzenden feuchtigkeitshärtenden Einkomponenten-Silikonkautschuks in Toluol (Viskosität ca. 350 mPa•s bei 23° C) wurde im Verhältnis 1:4 mit einem Isoparaffingemisch mit dem Siedebereich 116-136° C bei Normaldruck (Isopar E) verdünnt.

B) Eine Lösung von 5 Gewichtsteilen eines Dimethylpolysiloxans mit endständigen, an Silicium gebundenen OH-Gruppen, das eine Plastizität nach Brabender von 5,8 kNm aufweist, und 0,3 Gewichtsteilen einer Lösung eines Methylhydrogenpolysiloxans mit endständigen Trimethylsiloxygruppen mit einer Viskosität von 0,4 cm$^2$/s bei 25° C in 9,7 Gewichtsteilen Toluol wird mit 84 Gewichtsteilen einer 50 %igen Lösung des Umsetzungsprodukts aus 1,99 Gewichtsteilen eines Dimethylpolysiloxans mit endständigen OH-Gruppen (OH-Gruppengehalt 3,5 %) und 1 Gewichtsteil 3-(2-Amino-ethylamino)-propyltrimethoxysilan versetzt. Dann werden 0,3 Gewichtsteile Dibutylzinndiacetat zugegeben, und das Ganze wird vermischt. Dieser Lösung werden 0,4 Gewichtsteile Aminopropyltrimethoxysilan zugesetzt und damit vermischt.

C) 10 Gewichtsteile eines Dimethylpolysiloxans mit endständigen Vinyldimethylsiloxaneinheiten mit einer Viskosität von 7000 mPa•s bei 25° C wurden mit 0,025 Gewichtsteilen 2-Methyl-3-butin-2-ol, 0,03 Gewichtsteilen der unten beschriebenen Mischung aus Platinkomplex von Vinylsiloxan und Verdünnungsmittel, 0,09 Gewichtsteilen eines Mischpolymerisats aus 4 mol-% Trimethylsiloxan-, 72 mol-% Methylhydrogensiloxan- und 24 mol-% Dimethylsiloxaneinheiten mit einer Viskosität von 50 mPa•s bei 25° C und einem Gehalt von 1,36 % an Si gebundenen Wasserstoffs und 88,9 Gewichtsteilen Isopar E vermischt. Die Mischung läßt sich bis zu 24 Stunden nach der Herstellung verarbeiten.

Die Platinkomplex-Mischung wurde wie folgt hergestellt: Zu einer Mischung aus 10 Gewichtsteilen $H_2PtCl_6 \times 6H_2O$, 20 Gewichtsteilen 1,3-Divinyl-1,1,3,3-tetramethyldisiloxan und 50 Gewichtsteilen Ethanol wurden 20 Gewichtsteile Natriumhydrogencarbonat gegeben. Das Gemisch wurde 30 Minuten unter Rühren zum Sieden unter Rückfluß erhitzt, dann 15 Stunden stehen gelassen und danach filtriert. Aus dem Filtrat wurden bei 16 mbar die flüchtigen Bestandteile abdestilliert. Als Rückstand wurden 17 Gewichtsteile einer Flüssigkeit erhalten, die in Benzol gelöst wurde. Die Lösung wurde filtriert und aus dem Filtrat das Benzol abdestilliert. Der Rückstand wurde mit einem Dimethylpolysiloxan, das endständige Vinyldimethylsiloxaneinheiten hatte und eine Viskosität von 1,4 Pa•s bei 23° C aufwies, als Verdünnungsmittel in solcher Menge vermischt, daß das Gemisch 1 Gew.-% Platin, berechnet als Element, enthielt.

Beispiel 1

Auf eine elektrolytisch aufgerauhte und anodisch oxydierte Aluminiumplatte wurde eine Lösung von
3 Gt des Diazoniumsalz-Kondensationsprodukts aus 1 mol 3-Methoxy-diphenylamin-4-diazoniumsalz und 1 mol 4,4'-Bis-methoxymethyl-diphenylether, isoliert als Mesitylensulfonat,
3 Gt des Umsetzungsprodukts von 50 Gt eines Polyvinylbutyrals mit einem Molekulargewicht von 70000 bis 80000, das 71 % Vinylbutyral-, 2 % Vinylacetat- und 27 % Vinylalkoholeinheiten enthält, mit 4 Gt Maleinsäureanhydrid,
0,05 Gt $H_3PO_4$ (85 %) und
0,02 Gt Phenylazodiphenylamin in
93,93 Gt 2-Methoxy-ethanol
aufgebracht und getrocknet. Das Schichtgewicht betrug 1 g/m$^2$. Auf Proben der Platte wurden Deckschichten aus dem Silikonkautschuk A aufgebracht und zwecks Vernetzung 10 Minuten bei 100° C getrocknet

6

und 24 Stunden gelagert. Die Silikongummischichten hatten die folgenden Schichtgewichte:

   a) 3 g/m$^2$
   b) 2,1 g/m$^2$
   c) 0,9 g/m$^2$

Die Platten b und c wurden mit der Lösung B beschichtet und 3 Minuten bei 110° C getrocknet. Die erhaltenen Schichten hatten bei b 0,9 und bei c 2,1 g/m$^2$ Schichtgewicht. Die Platte a diente zum Vergleich.

Die so hergestellten Platten wurden jeweils 50, 70 und 90 s mit einer Metallhalogenidlampe (5 kW) unter einer Vorlage belichtet. Als Vorlage wurde ein Halbton-Stufenkeil mit 12 Dichtestufen von jeweils 0,15 verwendet, beginnend mit der Dichte 0,15 in Stufe 1.

Zur Auflösungsprüfung wurde ein Rasterstufenkeil im 60er Raster mit den folgenden prozentualen Flächendeckungen verwendet:

1 %; 2 %; 3 %; 4 %; 5 %; 95 %; 96 %; 97 %; 98 %; 99 %.

Die belichteten Platten wurden 6 Minuten in einer Entwicklerlösung mit einem oszillierenden Filz (Hub 4,8 mm, Oszillationsfrequenz 3000/min, Andruck 1500 N/m$^2$) behandelt. Die Entwicklerlösung setzte sich folgendermaßen zusammen:

40 Gt Gemisch von Isoparaffinen mit dem Siedebereich von 176 - 188° C,
27 Gt Tripropylenglykol,
30 Gt Diethylenglykoldimethylether.

Die Platten wurden mit Wasser gespült und mit Druckfarbe eingefärbt. Das Ergebnis ist in Tabelle 2 angegeben.

Beispiel 2 (Vergleichsbeispiel)

Eine Aluminiumplatte wurde wie in Beispiel 1 mit einer lichtempfindlichen Schicht versehen. Auf diese Platte wurde eine Silikonkautschukschicht aus Lösung B aufgebracht und 3 Minuten bei 110° C getrocknet. Das Schichtgewicht der Deckschicht betrug 3,5 g/m$^2$.

Die Platte wurde wie in Beispiel 1 beschrieben belichtet, entwickelt und eingefärbt. Das Ergebnis zeigt Tabelle 2.

Eine weitere Probe der Platte wurde auf einer handelsüblichen Offsetdruckmaschine (Heidelberger KOR) unter Verwendung einer handelsüblichen Farbe für den wasserlosen Offsetdruck und unter Entfernung des Feuchtwerks gedruckt. Nach 70000 Drucken wurden die 95 %-Punkte nicht mehr wiedergegeben; der Versuch wurde abgebrochen. Die Plattenoberfläche zeigte keine Kratzer.

Beispiel 3

Eine Aluminiumplatte wurde wie in Beispiel 1 mit einer lichtempfindlichen Schicht versehen. Auf diese Platte wurde eine Silikonkautschukschicht unter Verwendung der Lösung C aufgebracht und 3 Minuten bei 110° C getrocknet und vernetzt. Es wurden 6 verschiedene Platten mit den folgenden Silikonschichtgewichten erhalten:

```
a   3     g/m²
b   0,8   "
c   3,5   "
d   2     "
e   1     "
f   1,6   "
```

Auf die getrockneten Silikonkautschukschichten der Platten b, d, e und f wurden unterschiedlich dicke Schichten aus Lösung B aufgebracht und 3 Minuten bei 110° C getrocknet. Die Schichtgewichte der Silikongummischichten in g/m$^2$ waren wie folgt:

7

|   | Unterschicht (C) | Deckschicht (B) |
|---|---|---|
| b | 0,8 | 2,8 |
| d | 2 | 1 |
| e | 1 | 2 |
| f | 1,6 | 1,6 |

Die Platten wurden wie in Beispiel 1 belichtet, entwickelt und eingefärbt. Das Ergebnis zeigt Tabelle 2.

Von den oben beschriebenen Platten wurden drei auf der in Beispiel 2 angegebenen Druckmaschine wie dort beschrieben gedruckt. Die Ergebnisse zeigt die folgende Tabelle:

Tabelle I

| Platte | Unterschicht (C) (g/m$^2$) | Deckschicht (B) (g/m$^2$) | Auflage | Kratzer |
|---|---|---|---|---|
| c (V) | 3,5 | - | 110.000 | leichte ab 35.000 |
| b | 0,8 | 2,8 | 195.000 | keine |
| f | 1,6 | 1,6 | mehr als 135.000 | leichte ab 120.000 |

## Tabelle II

| Beispiel | Platte | Silikongummischicht | | Keilstufen | | | Auflösung, % Punkte im 60er Raster | | |
|---|---|---|---|---|---|---|---|---|---|
| | | Unterschicht | Deckschicht | 50s | 70 s | 90 s | 50 s | 70 s | 90 s |
| 1 | a (V) | 3  g/m² (A) | - | 3 | 4 | 4-5 | 98/2 | 98/2 | 98/2 |
| | | | Platte verkratzt | | | | | | |
| 1 | b | 2,1 "  " | 0,9 g/m² (B) | 5 | 6 | 7 | 99/2 | 99/3 | 99/4 |
| 1 | c | 0,9 "  " | 2,1 "  " | 6 | 7 | 8 | 99/3 | 99/4 | 99/5 |
| 2 | (V) | 3,5 " (B) | - | nach 6 Minuten nicht ausreichend entwickelt 99/10 (nach 10 Minuten Entwicklung) | | | | | |
| 3 | a (V) | 3 " (C) | - | 4 | 5 | 5-6 | 99/2 | 99/2 | 99/3 |
| 3 | b | 0,8 "  " | 2,8 g/m² (B) | 4 | 5 | 6 | 98/2 | 98/3 | 98/4 |
| 3 | c (V) | 3,5 "  " | - | 4 | 5 | 6 | 99/3 | 99/5 | 99/5 |
| 3 | d | 2 "  " | 1 "  " | 5 | 6 | 7 | 99/2 | 99/4 | 99/4 |
| 3 | e | 1 "  " | 2 "  " | 6 | 7 | 8 | 99/3 | 99/5 | 99/5 |
| 3 | f | 1,6 "  " | 1,6 "  " | 6 | - | - | 99/3 | - | - |

V = Vergleichsversuch

Beispiel 4

Auf eine elektrolytisch aufgerauhte und anodisch oxydierte Aluminiumplatte wurde eine Lösung von

EP 0 307 776 B1

2,3 Gt Polyethylenglykol-400-dimethacrylat,

1,9 " des in Beispiel 1 angegebenen polymeren Umsetzungsprodukts,

0,21 " 2-(4-Ethoxy-naphth-1-yl)-4,6-bis-trichlormethyl-s-triazin,

0,02 " Phenylazodiphenylamin und

0,05 " Phosphorsäure (85 %) in

95,52 " 2-Methoxy-ethanol

aufgebracht und getrocknet. Das Schichtgewicht betrug 1,4 g/m². Auf diese Platte wurde eine Schicht aus Silikonkautschuk C aufgebracht und 3 Minuten bei 110° C getrocknet. Das Schichtgewicht betrug 1 g/m². Darüber wurde dann eine Schicht aus Silikonkautschuk B aufgebracht und ebenfalls 3 Minuten bei 110° C getrocknet (Schichtgewicht 2 g/m²). Die Platte wurde wie in Beispiel 1 belichtet und entwickelt. Es ergab sich eine Druckform hoher Schärfe und Kratzfestigkeit.

Beispiel 5

Auf eine durch Bürsten aufgeraute Aluminiumplatte wurde eine filtrierte Lösung von

1,8 Gt des unten beschriebenen Naphthochinondiazid-sulfonsäureesters,

0,22 " Naphthochinon-(1,2)-diazid-(2)-4-sulfonyl-chlorid,

0,07 Gt 2,3,4-Trihydroxy-benzophenon,

6,6 " eines Kresol-Formaldehyd-Novolaks mit einem Schmelzbereich von 105 - 120°C nach DIN 53181 und

0,08 " Kristallviolett in

91,22 " eines Gemischs aus 5 Vt Tetrahydrofuran, 4 Vt Ethylenglykolmonomethylether und 1 Vt Butylacetat

aufgebracht und getrocknet.

Der in der obigen Rezeptur verwendete Naphthochinondiazidsulfonsäureester wurde wie folgt hergestellt:

Eine Lösung von 25,5 Gt Naphthochinon-(1,2)-diazid-(2)-5-sulfonsäurechlorid in 442 Gt Aceton wurde über Aktivkohle geklärt. In der Lösung wurden 26,3 Gt des oben angegebenen Kresol-Formaldehyd-Novolaks und 4,4 Gt 2,3,4-Tri-hydroxy-benzophenon gelöst und das Ganze mit einer Lösung von 11,9 Gt NaHCO$_3$ in 124 Gt Wasser und mit 160 Gt gesättigter Natriumchloridlösung versetzt. Das Gemisch wurde 10 Minuten gerührt, absitzen gelassen, die untere Phase verworfen und die Acetonlösung innerhalb weniger Minuten in eine Lösung aus 6 Gt HCl (30 %) und 1500 Gt Wasser einfließen gelassen. Das ausgeschiedene gelbe flockige Reaktionsprodukt wurde abgesaugt, mit Wasser ausgewaschen und getrocknet. Die Ausbeute betrug 48 Gt.

Auf das erhaltene lichtempfindliche Material wurde die folgende Lösung aufgeschleudert:

```
95,2  Gt entsalztes Wasser,
 4,8  Gt 30 %iges anionisches Kieselsäuresol mit
          einem Na₂O-Gehalt von ca. 0,15 % und einer
          Teilchengröße von 25 - 30 nm.
 0,04 Gt Nonylphenol-polyglykolether.
```

Der Teller der Plattenschleuder hatte dabei eine Drehzahl von etwa 175 U/Minute. Nach Trocknen der Schicht mit Warmluft wurde - bei ca. 110 U/Minute Lösung B aufgebracht und 3 Minuten bei 110° C getrocknet. Das Schichtgewicht betrug 1 g/m². Hierauf wurde Lösung C aufgebracht und 3 Minuten bei 110° C getrocknet.

Die Platten wurden belichtet und wie in Beispiel 1 entwickelt. Als Entwickler diente ein mit Natriummetasilikat gesättigtes trübes Gemisch aus 90 Vt Wasser, 9 Vt Isopropanol und 1 Vt eines aliphatischen Kohlenwasserstoffgemischs vom Siedebereich 116-142° C.

Die erhaltene Druckform lieferte saubere Drucke und wies eine äußerst kratzfeste Oberfläche auf.

**Patentansprüche**

1. Lichtempfindliche Druckplatte für den wasserlosen Flachdruck aus einem Schichtträger, einer darauf aufliegenden lichtempfindlichen Schicht und einer äußeren, Druckfarbe abstoßenden Silikongummischicht, dadurch gekennzeichnet, daß sich zwischen lichtempfindlicher Schicht und äußerer Silikongummischicht eine innere, Druckfarbe abstoßende Silikongummischicht befindet und daß die äußere Silikongummischicht stärker vernetzt ist als die innere Schicht.

2. Lichtempfindliche Druckplatte nach Anspruch 1, dadurch gekennzeichnet, daß das Silikongummi der äußeren Silikongummischicht ein kondensationsvernetzter Mehrkomponenten-Silikonkautschuk ist.

3. Lichtempfindliche Druckplatte nach Anspruch 1, dadurch gekennzeichnet, daß das Silikongummi der inneren Silikongummischicht ein additionsvernetzter Mehrkomponenten-Silikonkautschuk oder ein Einkomponenten-Silikonkautschuk ist.

4. Lichtempfindliche Druckplatte nach Anspruch 2, dadurch gekennzeichnet, daß der kondensationsvernetzte Mehrkomponenten-Silikonkautschuk das Reaktionsprodukt einer Kombination aus
   a) einem Diorganopolysiloxan mit endständigen Si-OH-Gruppen,
   b) einem Organopolysiloxan, das an Silicium gebundene Wasserstoffatome, aber keine Aminogruppen enthält,
   c) einer aminosubstituierten Organosiliciumverbindung und
   d) einer katalytisch wirkenden Organozinnverbindung ist.

5. Lichtempfindliche Druckplatte nach Anspruch 3, dadurch gekennzeichnet, daß der additionsvernetzte Mehrkomponenten-Silikonkautschuk das Reaktionsprodukt einer Kombination aus
   a) einem Diorganopolysiloxan mit endständigen Si-Vinylgruppen,
   b) einem Organopolysiloxan mit mindestens drei an Silicium gebundenen Wasserstoffatomen,
   c) einem Platinkomplex eines Vinylsiloxans und
   d) einem Mittel, das die Anlagerung von an Silicium gebundenen Wasserstoffatomen an aliphatische Mehrfachbindungen bei Raumtemperatur verzögert, ist.

6. Lichtempfindliche Druckplatte nach Anspruch 1, dadurch gekennzeichnet, daß die äußere Silikongummischicht eine Schichtdicke von 0,2 bis 10 µm hat.

7. Lichtempfindliche Druckplatte nach Anspruch 1, dadurch gekennzeichnet, daß die innere Silikongummischicht eine Schichtdicke von 0,1 bis 10 µm hat.

8. Lichtempfindliche Druckplatte nach Anspruch 1, dadurch gekennzeichnet, daß die lichtempfindliche Schicht eine lichthärtbare Schicht ist.

**9.** Lichtempfindliche Druckplatte nach Anspruch 1, dadurch gekennzeichnet, daß sie als lichtempfindliche Verbindung ein Diazoniumsalz-Polykondensationsprodukt enthält.

**10.** Verfahren zur Herstellung einer lichtempfindlichen Druckplatte für den wasserlosen Flachdruck, dadurch gekennzeichnet, daß man auf einen Schichtträger eine lichtempfindliche Schicht aufbringt, auf die lichtempfindliche Schicht eine Lösung eines additionsvernetzbaren Mehrkomponenten-Silikonkautschuks oder eines Einkomponenten-Silikonkautschuks aufbringt und bei erhöhter Temperatur trocknet und auf die getrocknete und mindestens teilweise vernetzte Silikonkautschukschicht eine Lösung eines kondensationsvernetzbaren Mehrkomponenten-Silikonkautschuks aufbringt und bei erhöhter Temperatur bis zur vollständigen Vernetzung trocknet.

**Claims**

**1.** A light-sensitive printing plate for waterless planographic printing, comprising a support, a superimposed light-sensitive layer and outer, ink-repellent silicone rubber layer, wherein an inner, ink-repellent silicone rubber layer is present between the light-sensitive layer and the outer silicone rubber layer and the outer silicone rubber layer shows a higher degree of crosslinking than the inner layer.

**2.** A light-sensitive printing plate as claimed in claim 1, wherein the silicone rubber of the outer silicone rubber layer comprises a condensation-crosslinked multi-component silicone elastomer.

**3.** A light-sensitive printing plate as claimed in claim 1, wherein the silicone rubber of the inner silicone rubber layer comprises an addition-crosslinked multi-component silicone elastomer or a single-component silicone elastomer.

**4.** A light-sensitive printing plate as claimed in claim 2, wherein the condensation-crosslinked multi-component silicone elastomer comprises the reaction product of a combination of
   a) a diorganopolysiloxane having terminal Si-OH groups,
   b) an organopolysiloxane containing hydrogen atoms bonded to silicon, but having no amino groups,
   c) an amino-substituted organo-silicon compound and
   d) a catalytically acting organo-tin compound.

**5.** A light-sensitive printing plate as claimed in claim 3, wherein the addition-crosslinked multi-component silicone elastomer comprises the reaction product of a combination of
   a) a diorganopolysiloxane having terminal Si-vinyl groups,
   b) an organopolysiloxane having at least three hydrogen atoms bonded to silicon,
   c) a platinum complex of a vinyl siloxane and
   c) an agent which retards the addition of hydrogen atoms bonded to silicon to aliphatic multiple bonds at room temperature.

**6.** A light-sensitive printing plate as claimed in claim 1, wherein the outer silicone rubber layer has a layer thickness ranging from 0.2 to 10 $\mu$m.

**7.** A light-sensitive printing plate as claimed in claim 1, wherein the inner silicone rubber layer has a layer thickness ranging from 0.1 to 10 $\mu$m.

**8.** A light-sensitive printing plate as claimed in claim 1, wherein the light-sensitive layer is a light-hardenable layer.

**9.** A light-sensitive printing plate as claimed in claim 1, wherein the light-sensitive compound comprises a diazonium salt polycondensation product.

**10.** A process for preparing a light-sensitive printing plate for waterless planographic printing, wherein a light-sensitive layer is applied to a support, the light-sensitive layer is coated with a solution of an addition-crosslinkable multi-component silicone elastomer or a single-component silicone elastomer and is dried at an elevated temperature and the dried and at least partially crosslinked silicone elastomer layer is coated with a solution of a condensation-crosslinkable multi-component silicone elastomer and is dried at an elevated temperature up to complete crosslinking.

**Revendications**

1. Plaque d'impression photosensible pour l'impression lithographique à sec, qui comprend un support, une couche photosensible déposée dessus et une couche externe de caoutchouc de silicone imperméable à l'encre, caractérisée en ce qu'une couche interne de caoutchouc de silicone imperméable à l'encre se trouve entre la couche photosensible et la couche de caoutchouc de silicone externe, et que la couche de caoutchouc de silicone externe est plus fortement réticulée que la couche interne.

2. Plaque d'impression photosensible selon la revendication 1, caractérisée en ce que le caoutchouc de silicone de la couche externe de caoutchouc de silicone est un élastomère de silicone multicomposant, réticulé par condensation.

3. Plaque d'impression photosensible selon la revendication 1, caractérisée en ce que le caoutchouc de silicone de la couche interne de caoutchouc de silicone est un élastomère de silicone multicomposant, réticulé par addition, ou un élastomère de silicone monocomposant.

4. Plaque d'impression photosensible selon la revendication 2, caractérisée en ce que l'élastomère de silicone multicomposant, réticulé par condensation, est le produit de la réaction d'une combinaison de :
    a) un diorganopolysiloxane à groupes Si-OH terminaux ;
    b) un organopolysiloxane renfermant des atomes d'hydrogène liés au silicium, mais pas de groupes amino ;
    c) un composé organosilicique substitué par des groupes amino ; et
    d) un composé organo-étain à action catalytique.

5. Plaque d'impression photosensible selon la revendication 3, caractérisée en ce que l'élastomère de silicone multicomposant, réticulé par addition, est le produit de la réaction d'une combinaison de :
    a) un diorganopolysiloxane à groupes Si-vinyle terminaux ;
    b) un organopolysiloxane avec au moins trois atomes d'hydrogène liés à du silicium ;
    c) un complexe du platine d'un vinylsiloxane ; et
    d) un agent qui retarde, a température ambiante, l'addition des atomes d'hydrogène liés au silicium sur des liaisons multiples aliphatiques.

6. Plaque d'impression photosensible selon la revendication 1, caractérisée en ce que la couche externe de caoutchouc de silicone présente une épaisseur de 0,2 à 10 $\mu$m.

7. Plaque d'impression photosensible selon la revendication 1, caractérisée en ce que la couche interne de caoutchouc de silicone présente une épaisseur de 0,1 à 10 $\mu$m.

8. Plaque d'impression photosensible selon la revendication 1, caractérisée en ce que la couche photosensible est une couche photodurcissable.

9. Plaque d'impression photosensible selon la revendication 1, caractérisée en ce qu'elle contient, comme composé photosensible, un polycondensat de sel de diazonium.

10. Procédé de fabrication d'une plaque d'impression photosensible pour l'impression lithographique à sec, qui est caractérisée en ce qu'on dépose sur un support une couche photosensible, on dépose sur la couche photosensible une solution d'un élastomère de silicone multicomposant, réticulable par addition, ou d'un élastomère de silicone monocomposant, on sèche l'ensemble à haute température, on dépose sur la couche d'élastomère de silicone séchée et au moins partiellement réticulée une solution d'un élastomère de silicone multicomposant, réticulable par condensation, et on sèche à température élevée jusqu'à réticulation complète.